# EUROPEAN PATENT APPLICATION

(11) **EP 3 363 927 A1**
(43) Date of publication of application: **22.08.2018**
(21) Application number: 16855174.5
(22) Date of filing: 18.08.2016
(51) Int. Cl.: C23C 14/34, C04B 35/00, H01M 4/525

(54) **LICOO2-CONTAINING SINTERED COMPACT, LICOO2-CONTAINING SPUTTERING TARGET, AND LICOO2-CONTAINING SINTERED COMPACT MANUFACTURING METHOD**

(30) Priority: 15.10.2015 JP 2015203796
(71) Applicant: Kobelco Research Institute, Inc., Kobe-shi, Hyogo 651-0073 (JP)
(72) Inventor: TAKETOMI, Yuichi, Hyogo 676-8670 (JP); YOSHIDA, Shintaro, Hyogo 676-8670 (JP); KANAMARU, Moriyoshi, Hyogo 676-8670 (JP)
(74) Representative: Müller-Boré & Partner Patentanwälte PartG mbB
(86) International application number: PCT/JP2016/074140
(87) International publication number: WO 2017/064920

(57) **Abstract**

To realize a sintered compact containing LiCoO₂ which can increase a film deposition rate during sputtering, particularly even when a film is deposited only by pulsed DC discharge sputtering and can suppress the generation of flakes due to sputtering, and which is hardly cracked and is easy to handle.

In the sintered compact containing LiCoO₂, an average grain size is 10 to 40 µm, a relative density is 90% or more, and a resistivity is 100 Ω·cm or less.

## Description

### Technical Field

The present disclosure relates to a sintered compact containing LiCoO₂ and a sputtering target containing LiCoO₂, and a method for manufacturing a sintered compact containing LiCoO₂. Particularly, the present disclosure relates to a sintered compact containing LiCoO₂ which can increase a film deposition rate without causing abnormal discharge during sputtering and can suppress the generation of flakes due to sputtering, and which is hardly cracked and is easy to handle; a sputtering target containing LiCoO₂ formed of the sintered compact containing LiCoO₂; and a method for manufacturing the sintered compact containing LiCoO₂.

### Background Art

Application of a thin film secondary battery to the field of wearable devices is expected to expand by utilizing features such as high sensitivity and small size/lightweight, compared with a lithium ion secondary battery using an organic electrolyte solution. There may be typically mentioned, as the thin film secondary battery, a Li-based thin film secondary battery composed of a positive electrode formed of a thin film containing LiCoO₂ which contains Li and Co of transition metal, a solid electrolyte containing Li, and a negative electrode formed of a Li metal thin film and the like.

For film deposition of a thin film containing LiCoO₂ constituting the positive electrode in a structure of the Li-based thin film secondary battery, a sputtering method of sputtering a sputtering target (hereinafter sometimes abbreviated to a target) formed of the same material as that of the film, i.e. a lithium cobaltate target is suitably used. The sputtering method has an advantage that it is easy to adjust film deposition conditions, thus a film is easily deposited on a semiconductor substrate.

By the way, there is a need for the Li-based thin film secondary battery to achieve higher capacity, thus an increase in film thickness of a positive electrode material, i.e. thickening of a thin film containing LiCoO₂ is required. Therefore, to increase the thickness of the thin film containing LiCoO₂, a target capable of performing film deposition at a high rate is required. However, composite oxides such as lithium cobaltate have a problem such as comparatively small conductivity. When film deposition is performed by pulsed direct current (DC) discharge sputtering having a high film deposition rate so as to thicken the thin film containing LiCoO₂, micro-arc discharge due to charge of the target often occurs, and thus a problem that the deposited film is easily damaged is caused. Meanwhile, when radio frequency (RF) discharge sputtering is performed in place of the pulsed DC discharge sputtering, the film deposition rate decreases, and thus productivity is degraded.

A ceramics-based target such as a lithium cobaltate target has a problem that flakes are easily generated during sputtering and thus quality of the thin film is degraded. To suppress the generation of flakes, it is commonly required to improve a relative density of the target. Furthermore, since the ceramics-based target is easily cracked when an average grain size increases, it is also required to control the average grain size. Namely, there is a need for the target used for formation of the thin film containing LiCoO₂ to exhibit low resistivity and to satisfy high relative density and appropriate average grain size.

For example, technology of Patent Document 1 has been proposed as those in which an examination was made of the above-mentioned properties of the lithium cobaltate target. Patent Document 1 relates to a method for manufacturing a LiCoO₂ sintered compact, and a sputtering target, and the patent document mentions, as the manufacturing method, a method in which a LiCoO₂ powder is preformed by cold isostatic pressure pressing method under a pressure of 1,000 kg/cm² or more, and then the preformed compact of the LiCoO₂ powder is sintered at a temperature of 1,050°C or higher and 1,120°C or lower. It is also mentioned that in the sputtering target formed of the LiCoO₂ sintered compact obtained by the method, a relative density is 90% or more, a resistivity is 3 kΩ·cm or less, and an average grain size is 20 µm or more and 50 µm or less. It is also mentioned that the sintered compact can suppress the generation of particles, and thus it is possible to stably sputter by superposing discharge of DC power and high frequency power.

As is mentioned in Patent Document 1, it is preferred to reduce the resistivity of the sintered compact, however, the resistivity of the sintered compact mentioned in Patent Document 1 is minimum 500 Ω·cm and in truth a sintered compact having lower resistivity is hardly realized. Particularly in Patent Document 1, film deposition is performed by superposing discharge of DC + RF, however, when film deposition is performed only by pulsed DC discharge sputtering so as to make the film deposition rate higher, the resistivity of the level equivalent to Patent Document 1 may hardly increase the film deposition rate.

Therefore, there has been required, as the target used for formation of the thin film containing LiCoO₂, a target which can increase a film deposition rate without causing abnormal discharge even when film deposition is performed only by pulsed DC discharge sputtering and can suppress the generation of flakes due to sputtering, and which is hardly cracked and is easy to handle.

### Prior Art Document

### Patent Document

Patent Document 1: WO 2011/086650 A

### Summary of the Invention

### Problems to be Solved by the Invention

The embodiment of the present invention has been made by focusing attention on the above-mentioned circumstances, and an object thereof is to establish a sintered compact containing LiCoO₂ which can increase a film deposition rate during sputtering, particularly even when a film is deposited only by pulsed DC discharge sputtering and can suppress the generation of flakes due to sputtering, and which is hardly cracked and is easy to handle; a sputtering target containing LiCoO₂ formed of the sintered compact containing LiCoO₂; and a method for manufacturing the sintered compact containing LiCoO₂ .

### Means for Solving the Problems

In a sintered compact containing LiCoO₂ of the embodiment of the present invention that can solve the foregoing problems, an average grain size is 10 to 40 µm, a relative density is 90% or more, and a resistivity is 100 Ω·cm or less.

A sputtering target containing LiCoO₂ which is formed of the sintered compact containing LiCoO₂ is also included in the embodiment of the present invention.

A method for manufacturing a sintered compact containing LiCoO₂ of the embodiment of the present invention that can solve the foregoing problems is characterized by including a step of using a powder containing LiCoO₂ and sintering the powder by hot pressing method to obtain a precursory sintered compact having a relative density of 78% or more and less than 93%; a first heat treatment step of retaining the precursory sintered compact under an atmosphere containing oxygen at 800°C or higher and lower than 1,000°C for 1 to 50 hours; and a second heat treatment step of retaining under an atmosphere containing oxygen or an inert atmosphere at 1,050 to 1,150°C for 1 to 50 hours, in this order.

In the preferred embodiment of the present invention, the sintering by the hot pressing method is performed at a temperature of 700°C or higher and lower than 1,000°C under a pressure of 10 to 100 MPa.

### Effects of the Invention

According to the embodiment of the present invention, it is possible to provide a sintered compact containing LiCoO₂, a sputtering target containing LiCoO₂ and a method for manufacturing the sintered compact containing LiCoO₂, which can increase a film deposition rate without causing abnormal discharge even when pulsed DC discharge sputtering is performed and can suppress the generation of flakes due to sputtering, and which are hardly cracked and are easy to handle; and a method for manufacturing the sintered compact containing LiCoO₂.

### Mode for Carrying Out the Invention

The inventors of the present invention have intensively studied so as to obtain a sintered compact containing LiCoO₂ which can increase a film deposition rate during sputtering, particularly even when a film is deposited only by pulsed DC discharge sputtering and can suppress the generation of flakes due to sputtering, and which is hardly cracked and is easy to handle. As a result, they have found that: the film deposition rate can be sufficiently increased by suppressing the resistivity of the sintered compact containing LiCoO₂ to 100 Ω·cm or less; the generation of flakes due to sputtering can be suppressed by setting the relative density at 90% or more; and it is hardly cracked and is easy to handle by setting the average grain size in a range of 10 to 40 µm.

The sintered compact containing LiCoO₂ of the embodiment of the present invention will be described in detail below.

### (Sintered Compact containing LiCoO₂)

The sintered compact containing LiCoO₂ of the embodiment of the present invention contains lithium cobaltate (LiCoO₂). In the sintered compact containing LiCoO₂, the ratio of LiCoO₂ to the whole sintered compact is preferably 50% by mass or more, more preferably 80% by mass or more, and further preferably 90% by mass or more. Most preferably, the whole (100% by mass) of the sintered compact is formed of LiCoO₂. The component other than LiCoO₂ includes, for example, transition metals other than Co (Mn, Fe or Ni) or composite oxides of Li and transition metals other than Co.

The sintered compact containing LiCoO₂ of the embodiment of the present invention has an average grain size of 10 to 40 µm. If the average grain size of the sintered compact is too large, the sintered compact is easily cracked during handling as a target, as mentioned above. Therefore, the average grain size of the sintered compact is set at 40 µm or less. The average grain size is preferably 30 µm or less, and more preferably 20 µm or less. Meanwhile, it is not easy to obtain the above relative density even if the average grain size of the target is too small, so that the average grain size is set at 10 µm or more. The average grain size is preferably 15 µm or more.

The sintered compact containing LiCoO₂ of the embodiment of the present invention satisfies that the relative density of the whole sintered compact is 90% or more. As the relative density becomes higher, the generation of flakes during sputtering can be suppressed and stable discharge can be continuously maintained until target life. The higher the relative density the better, and the relative density is preferably 92% or more, and more preferably 93% or more. The upper limit of the relative density is not particularly limited from the above viewpoint, however, it is preferably about 99% or less in view of productivity.

Furthermore, in the sintered compact containing LiCoO₂ of the embodiment of the present invention, the resistivity is 100 Ω·cm or less. Such low resistivity enables sufficient enhancement in film deposition rate even when film deposition is performed only by pulsed DC discharge sputtering, and thus thickening of the above-mentioned thin film containing LiCoO₂ is realized without causing degradation of productivity. The resistivity is preferably 80 Ω·cm or less, and more preferably 50 Ω·cm or less. The smaller the resistivity the better, however, the lower limit of the resistivity is about 5 Ω·cm.

The shape of the sintered compact is not particularly limited and may be any one of a plate shape, a disk shape, or a cylindrical shape.

### (Method for Manufacturing Sintered Compact containing LiCoO₂)

The method for manufacturing a sintered compact containing LiCoO₂ will be described below. The method for manufacturing a sintered compact containing LiCoO₂ of the embodiment of the present invention is characterized by including the following steps (1) and (2) in order. The manufacturing method of the embodiment of the present invention will be described in detail below.
(1) Step of using a powder containing LiCoO₂ and sintering the powder by hot pressing method to obtain a precursory sintered compact having a relative density of 78% or more and less than 93%
(2) Step of performing a heat treatment in two stages, which consists of a first heat treatment step of retaining the precursory sintered compact under an atmosphere containing oxygen at 800°C or higher and lower than 1,000°C for 1 to 50 hours; and a second heat treatment step of retaining under an atmosphere containing oxygen or an inert atmosphere at 1,050 to 1,150°C for 1 to 50 hours
   (1) Step of using a powder containing LiCoO₂ and sintering the powder by hot pressing method to obtain a precursory sintered compact having a relative density of 78% or more and less than 93%

### (Raw Material Powder)

A powder containing LiCoO₂ is used as a raw material powder. The powder may contain other composite oxides according to the composition of the sintered compact. In the embodiment of the present invention, there is no need to use a special powder as a powder containing LiCoO₂ and, for example, a commercially available LiCoO₂ powder can be used as it is. In view of obtaining a sintered compact having an average grain size of 10 to 40 µm, it is possible to use, as the raw material powder, a raw material powder having an average grain size D₅₀, for example, in a range of 5 to 10 µm.

In the method for manufacturing a sintered compact containing LiCoO₂ according to the embodiment of the present invention, hot pressing method is employed. According to this hot pressing method, it is possible to comparatively easily control the relative density by the assisting effect due to pressurization even at a low sintering temperature.

In the hot pressing method, a graphite mold or a ceramics mold can be used. Of these molds, a graphite mold, usable regardless of the size, is preferable.

Description will be made of sintering by hot pressing method using a graphite mold as an example.

The raw material powder is filled into a graphite mold. In the case of filling into a graphite mold, the raw material powder may be directly filled into the graphite mold without preforming, or may be filled once into another mold and preformed by a mold press, followed by filling of the preformed compact into the graphite mold. The latter preforming is performed for the purpose of improving handleability when the preformed compact is placed in a predetermined mold in the hot pressing step, and the raw material powder may preferably be made into a preformed compact by applying a pressure of, for example, about 0.5 to 1.0 tonf/cm².

In the embodiment of the present invention, the atmosphere during heating before sintering (atmosphere of a temperature rising process to the sintering temperature) and the atmosphere during sintering are preferably inert atmospheres. The gas used for inert atmosphere includes, for example, nitrogen and argon.

The temperature during sintering by the hot pressing method is preferably controlled in a range of 700°C or higher and lower than 1,000°C, while the pressure during sintering is preferably controlled in a range of 10 to 100 MPa.

By setting the sintering temperature at 700°C or higher, the relative density of the sintered compact is improved. The sintering temperature is more preferably 800°C or higher. By setting the sintering temperature at lower than 1,000°C, the relative density of the precursory sintered compact is suppressed to less than 93%, and thus it is possible to sufficiently recover oxygen deficiency by a heat treatment in the subsequent step, as mentioned below. The sintering temperature is more preferably 950°C or lower.

By setting the pressure during sintering at 10 MPa or more, the relative density of the sintered compact is improved. The pressure is more preferably 20 MPa or more. By setting the pressure during sintering at 100 MPa or less, it is possible to suppress breaking of a mold for hot pressing, such as a graphite mold. The pressure is more preferably 50 MPa or less.

In this way, a precursory sintered compact before a heat treatment is obtained. The precursory sintered compact is manufactured under the recommended conditions to suppress the relative density to less than 93%. The resistivity of a sintered compact containing LiCoO₂ increases by oxygen deficiency. In the embodiment of the present invention, to recover oxygen deficiency, a heat treatment is performed under an air atmosphere, preferably an oxygen atmosphere, as mentioned below. To reduce the resistivity by recovering oxygen deficiency over the whole precursory sintered compact, there is a need to suppress the relative density of the precursory sintered compact to less than 93%. If the relative density of the precursory sintered compact is 93% or more, oxygen is hardly distributed to the whole precursory sintered compact during a heat treatment in the subsequent step, and it is difficult to sufficiently recover oxygen deficiency, arid thus an increase in resistivity occurs. The relative density of the precursory sintered compact is more preferably 91% or less, and further preferably 90% or less. Meanwhile, if the relative density of the precursory sintered compact is too low, the precursory sintered compact is easily cracked. Therefore, the relative density of the precursory sintered compact is set at 78% or more, and preferably 80% or more.

In the embodiment of the present invention, the product obtained after sintering by the hot pressing method and before the below-mentioned two-stage heat treatment refers to a "precursory sintered compact", while the product obtained by subjecting the precursory sintered compact to the below-mentioned two-stage heat treatment refers to a "sintered compact".
(2) Step of performing a heat treatment in two stages, which consists of a first heat treatment step of retaining the precursory sintered compact under an atmosphere containing oxygen at 800°C or higher and lower than 1,000°C for 1 to 50 hours; and a second heat treatment step of retaining under an atmosphere containing oxygen or an inert atmosphere at 1,050 to 1,150°C for 1 to 50 hours

As mentioned above, in the embodiment of the present invention, it is important to perform a heat treatment under two-stage heating conditions as mentioned below so as to noticeably reduce the resistivity by recovering oxygen deficiency. Specifically, the heat treatment is performed by passing through a first heat treatment step of retaining under an atmosphere containing oxygen at 800°C or higher and lower than 1,000°C for 1 to 50 hours, followed by a second heat treatment step of retaining under an atmosphere containing oxygen or inert atmosphere at 1,050 to 1,150°C for 1 to 50 hours. In the first heat treatment step, low resistivity is realized without hardly changing the relative density of the precursory sintered compact and, in the subsequent second heat treatment step, the relative density of the sintered compact with lowered resistivity is increased to 90% or more and the average grain size is increased to 10 to 40 µm.

In the first heat treatment step, for the purpose of achieving the object, the first heat treatment temperature is set at 800°C or higher, and preferably 850°C or higher. The first heat treatment time is set at 1 hour or more, and preferably 5 hours or more. If the first heat treatment temperature is too high or the first heat treatment time is too long, the relative density of the precursory sintered compact increases more than necessary, and it is difficult to distribute oxygen to the whole precursory sintered compact, and thus low resistivity cannot be realized. Therefore, the first heat treatment temperature is set at lower than 1,000°C, preferably 980°C or lower, and more preferably 950°C or lower, while the first heat treatment time is set at 50 hours or less, and preferably 20 hours or less.

After the first heat treatment step, a second heat treatment step is subsequently carried out. In this second heat treatment step, to increase the relative density of the sintered compact with lowered resistivity and to increase the average grain size, the second heat treatment temperature is set at 1,050°C or higher, and preferably 1,080°C or higher. The second heat treatment time is set at 1 hour or more, and preferably 10 hours or more. Meanwhile, if the second heat treatment temperature is too high or the second heat treatment time is too long, the average grain size excessively increases, and thus crack of the sintered compact may occur and low resistivity may not be realized. Therefore, the second heat treatment temperature is set at 1,150°C or lower, and preferably 1,130°C or lower. The second heat treatment time is set at 50 hours or less, and preferably 30 hours or less.

In the first heat treatment step and the second heat treatment step, "retaining" at each temperature can include, in addition to maintaining at a constant temperature in each temperature range, the rise or fall of the temperature.

In the first heat treatment step, the atmosphere is set to an atmosphere containing oxygen. Whereby, recovery of oxygen deficiency proceeds, and thus the resistivity of the sintered compact is reduced. The atmosphere containing oxygen includes, for example, an atmosphere containing 20% by volume or more of oxygen, and typically an air atmosphere. The atmosphere containing oxygen is preferably an atmosphere containing 50% by volume or more, more preferably 90% by volume or more, and further preferably 100% by volume, of oxygen.

In the second heat treatment step, the atmosphere may be set to an atmosphere containing oxygen or an inert atmosphere. The atmosphere containing oxygen includes an atmosphere which is the same as that of the first heat treatment step. The inert atmosphere includes nitrogen and argon.

The sintered compact thus obtained is used as a sputtering target after optionally subjecting to machining. It is also possible for the sputtering target of the embodiment of the present invention to have the same size as that of the thus obtained sintered compact. The shape of the sputtering target is not particularly limited may be any one of a plate shape, a disk shape, or a cylindrical shape. The sputtering target of the embodiment of the present invention also have all of properties (high relative density, low resistivity, and appropriate average grain size) which are the same as those of the sintered compact. Therefore, the sputtering target is easy to handle and can increase a film deposition rate during sputtering, particularly even when a film is deposited only by pulsed DC discharge sputtering, and also can suppress the generation of flakes during sputtering. Accordingly, it is possible to form a thin film containing LiCoO₂ having a large thickness and satisfactory properties in good productivity, and this contributes to practical application of a Li-based thin film secondary battery having high capacity and satisfactory properties.

### Examples

Embodiments of the present invention will be more specifically described below by way of Examples. It is to be understood that the present invention is not limited to the following Examples, and various design variations made in accordance with the purports described hereinbefore and hereinafter are also included in the technical scope of the present disclosure.

### (Fabrication Sintered Compact)

As a raw material powder, a commercially available lithium cobaltate powder (fine grained material having a purity of 99.9% or more and an average grain size of 10 µm or less) was used. The raw material powder was directly filled into a graphite mold and then sintered by hot pressing to obtain a sintered compact before a heat treatment, i.e. a precursory sintered compact. Hot pressing was performed under the following sintering conditions: a nitrogen atmosphere was used as the inert atmosphere; the temperature was set at each temperature of the "hot pressing temperature" shown in Table 1; and the pressure was set at 30 MPa. The relative density of the obtained precursory sintered compact and the presence/absence of cracks were evaluated. The relative density and the presence/absence of cracks of the precursory sintered compact were evaluated by the same evaluation method as that of the relative density and the presence/absence of cracks of the below-mentioned sintered compact. With respect to the precursory sintered compact in which a decision was made that cracks "exist" in the evaluation of the presence/absence of cracks of the precursory sintered compact, subsequent step/evaluation was not performed. The results are shown in Table 1.

Subsequently, the precursory sintered compact was subjected to a heat treatment under the conditions shown in Table 1 to obtain a sintered compact. The heat treatment conditions of No. 8 in Table 1 below show that the heat treatment is a one-stage heat treatment at 900°C for 11 hours. In Examples, an "oxygen" atmosphere of the heat treatment in Table 1 was set to an atmosphere containing 50% by volume of oxygen.

An average grain size, a relative density, a resistivity and discharge properties of the obtained sintered compact were evaluated by the following procedures. The presence/absence of cracks of the sintered compact was visually observed.

### [Method for Measurement of Average Grain Size]

The average grain size was determined as follows. A sample collected from the sintered compact was embedded in a resin and a cross section was polished to expose the cross section of the sample. This polished surface was observed by a scanning electron microscope (SEM) and the average grain size was determined from a SEM micrograph at a magnification of 500 times using cutting method (JIS H 0501: 1986).

### [Method for Measurement of Relative Density]

A theoretical density of lithium cobaltate is assumed to be 5.06 g/cm³, and an apparent density of the sintered compact measured by the Archimedes method was divided by the theoretical density to determine the relative density.

### [Method for Measurement of Resistivity]

The resistivity was measured by the four probe method. Specifically, using a resistivity meter Loresta GP manufactured by Mitsubishi Chemical Analytech Co., Ltd., measurement was made in a state where a probe having a terminal-spacing distance of 1.5 mm is in contact with a sintered compact, and an average of measured values at arbitrary five positions was regarded as the resistivity.

### [Evaluation of Discharge Properties]

Using the obtained sintered compact as a target, film deposition was performed by sputtering under the below-mentioned conditions. A film deposition rate and a flake generation amount were determined as discharge properties during sputtering.

### (Sputtering Conditions)

Film deposition apparatus: DC magnetron sputtering apparatus Film deposition conditions: substrate temperature: 20°C, a pulsed DC power supply is connected, pulsed DC discharge power: 500 W, sputtering gas pressure: 1 mTorr, sputtering gas: Ar gas

### (Procedure of Film Deposition)

Each target was mounted on the film deposition apparatus and a glass substrate (having a size of 50 mm x 50 mm) was placed on a substrate stage opposite to the target. The pressure inside a chamber was reduced to 8 × 10⁻⁴ Pa or lower by a vacuum pump. Then, the sputtering gas was fed into the chamber using a mass flow. After adjusting the sputtering gas pressure to 1 mTorr, a high voltage of 500 W was applied to the target using a pulsed DC power supply to cause plasma discharge

### (Method for Measurement of Film Deposition Rate)

The film deposition rate was determined as follows. A mask was placed on a glass substrate, followed by film deposition for 30 minutes. Using a probe type step profiler (manufactured by Yamato Scientific Co., Ltd. Alpha-Step IQ), a step of a thin film formed when removing the mask was measured. Then, the step of the thin film was divided by the film deposition time of 30 minutes to determine the film deposition rate. The case where the film deposition rate is 80 nm/min or more was rated as a high film deposition rate. The film deposition rate is preferably 85 nm/min or more, more preferably 90 nm/min or more, and further preferably 95 nm/min or more.

### (Method for Measurement of Flake Generation Amount)

The flake generation amount was determined as follows. After film deposition for 30 hours, flakes fell on a substrate stage were gathered and the mass was measured. The case where the flake generation amount is 35 mg or less was rated as "good" since the generation of flakes is sufficiently suppressed. The case where the flake generation amount is more than 35 mg and less than 70 mg was rated as "insufficient" since flakes are slightly generated. The case where the flake generation amount is 70 mg or more was rated as "bad" since numerous flakes are generated.

These measurement results are shown in Table 1.

**[Table 1]**

| No. | Precursory sintered compact | | Cracks of precursory sintered compact | Heat treatment conditions | | | | | Properties of sintered compact | | | Cracks of sintered compact | Discharge properties | |
|---|---|---|---|---|---|---|---|---|---|---|---|---|---|---|
| | Hot pressing temperature | Relative density | | Atmosphere | First heat treatment | | Second heat treatment | | Average grain size | Relative density | Resistivity | | Flake generation amount | Film deposition rate |
| | | | | | Temperature | Time (hr) | Temperature | Time | | | | | | |
| | (°C) | (%) | | | (°C) | | (°C) | (hr) | (µm) | (%) | (Ω·cm) | | | (nm/min) |
| 1 | 890 | 80 | None | Oxygen | 900 | 11 | 1,100 | 20 | 18 | 92 | 15 | None | Good | 98 |
| 2 | 930 | 88 | None | Oxygen | 900 | 11 | 1,100 | 20 | 18 | 93 | 11 | None | Good | 101 |
| 3 | 950 | 90 | None | Oxygen | 900 | 11 | 1,100 | 20 | 18 | 94 | 45 | None | Good | 98 |
| 4 | 930 | 88 | None | Oxygen | 900 | 11 | 1,100 | 50 | 40 | 95 | 100 | None | Good | 95 |
| 5 | 930 | 88 | None | Air atmosphere | 900 | 11 | 1,100 | 20 | 18 | 93 | 100 | None | Good | 94 |
| 6 | 700 | 76 | Exist | - | - | - | - | - | - | - | - | - | - | - |
| 7 | 1,000 | 93 | None | Oxygen | 900 | 11 | 1,100 | 20 | 18 | 93 | 550 | None | Good | 79 |
| 8 | 930 | 88 | None | Oxygen | 900 | 11 | - | - | 4 | 88 | 12 | None | Bad | 100 |
| 9 | 930 | 88 | None | Oxygen | 900 | 11 | 1,100 | 60 | 55 | 95 | 110 | Exist | - | - |

From Table 1, the following can be seen. Regarding Nos. 1 to 5, sintered compacts were fabricated by the method defined in the embodiment of the present invention. Of these, regarding Nos. 1 to 4, a heat treatment was performed under an oxygen atmosphere and, regarding No. 5, a heat treatment was performed under an air atmosphere. In all examples, the obtained sintered compacts and targets exhibited the relative density, the resistivity and the average grain size in a defined range, namely, high relative density was attained, and the resistivity was sufficiently suppressed. Sputtering using the target could ensure high film deposition rate and sufficiently suppressed the flake generation amount. To sufficiently suppress the resistivity, like Nos. 1 to 3 of these examples, it is preferred that the atmosphere of the first heat treatment step of manufacturing conditions is set to an oxygen atmosphere and the time of the second heat treatment step is controlled, specifically, the time is not prolonged.

Meanwhile, regarding Nos. 6 to 9, since the sintered compacts and targets were not manufactured by the method defined in the embodiment of the present invention, excellent properties of the sintered compact could not be obtained and, as a result, at least one of cracks and discharge properties of the target are not preferable. Specifically, regarding No. 6, because of too low relative density of the precursory sintered compact, cracks occurred at a stage of a precursory sintered compact.

Regarding No. 7, because of too high relative density of the precursory sintered compact, high resistivity is attained even if the defined two-stage heat treatment is performed, and the film deposition rate was decreased. Regarding No. 8, since the heat treatment step was performed at one stage, like a conventional method, the obtained sintered compact exhibited low relative density, and flake generation amount was increased. Regarding No. 9, a two-stage heat treatment was performed, however, the time of the second heat treatment was too long, the resistivity increased and the average grain size increased, and thus cracks of the target occurred.

The application claims priority to Japanese Patent Application No. 2015-203796 filed on October 15, 2015, the disclosure of the application is incorporated by reference herein.

## Claims

1. A sintered compact containing LiCoO₂, wherein
an average grain size is 10 to 40 µm,
a relative density is 90% or more, and
a resistivity is 100 Ω·cm or less.

2. A sputtering target containing LiCoO₂ which is formed of the sintered compact containing LiCoO₂ according to claim 1.

3. A method for manufacturing the sintered compact containing LiCoO₂ according to claim 1, comprising:
a step of using a powder containing LiCoO₂ and sintering the powder by hot pressing method to obtain a precursory sintered compact having a relative density of 78% or more and less than 93%;
a first heat treatment step of retaining the precursory sintered compact under an atmosphere containing oxygen at 800°C or higher and lower than 1,000°C for 1 to 50 hours; and a second heat treatment step of retaining under an atmosphere containing oxygen or an inert atmosphere at 1,050 to 1,150°C for 1 to 50 hours, in this order.

4. The method according to claim 3, wherein the sintering by the hot pressing method is performed at a temperature of 700°C or higher and lower than 1,000°C under a pressure of 10 to 100 MPa.
